# EUROPEAN PATENT APPLICATION

(11) **EP 4 391 036 A1**
(43) Date of publication of application: **26.06.2024**
(21) Application number: 23215808.9
(22) Date of filing: 12.12.2023
(51) Int. Cl.: H01L 21/768, H01L 23/485, H01L 23/528

(54) **BACKSIDE CONTACT FORMATION USING PILLAR PATTERNING**

(30) Priority: 16.12.2022 US 202263433055 P; 21.02.2023 US 202363447227 P; 28.04.2023 US 202318141313
(71) Applicant: Samsung Electronics Co., Ltd., Suwon-si, Gyeonggi-do 16677 (KR)
(72) Inventor: KIM, Tae Sun, San Jose, CA 95134 (US); HONG, Wonhyuk, San Jose, CA 95134 (US); LEE, Jongjin, San Jose, CA 95134 (US); HAM, Buhyun, San Jose, CA 95134 (US); SEO, Kang-ill, San Jose, CA 95134 (US)
(74) Representative: Kuhnen & Wacker Patent- und Rechtsanwaltsbüro PartG mbB

(57) **Abstract**

In order to achieve higher contact quality for backside power distribution networks, provided is a backside contact to a semiconductor device having a positive slope and a dielectric sidewall liner, and methods for making the same.

## Description

### FIELD

The present disclosure relates to semiconductor devices having backside contacts connecting semiconductor terminals to backside power rails, and met9hods for forming the same.

### BACKGROUND

This background section is intended to familiarize the reader with the technological context of the disclosure and to enable more complete comprehension of the concepts presented herein. Thus, it may contain information known or developed by the inventors that is not available to the public, and should not be interpreted as prior art.

Traditionally, semiconductor devices are provided on (or in) a substrate, in a front-end-of-line (FEOL) layer. Above this layer is a middle-of-line layer (MOL), comprised of an inter-layer dielectric (ILD) and contacts connecting the semiconductor devices with the layers above. Above the MOL layer is provided a series of signal and power routing lines, and interconnections between said layers, collectively referred to as the back-end-of-line (BEOL) region.

However, as semiconductor node sizes shrink, the number of devices per unit area has increased dramatically. As a result, the signal and power line space in the BEOL above the semiconductor devices are becoming increasingly congested. A possible solution is to move at least some of the power lines (or rails) to a level beneath the FEOL layers, in or below the level of the substrate- that is, located on the opposite side of the FEOL layers from the MOL and traditional BEOL layers. This would create a backside power distribution network (BSPDN).

In order to fully realize a BSPDN, new forms of contact between the BSPDN power rails and the device terminals is required.

### SUMMARY

According to some embodiments, what is provided is a semiconductor unit comprising: a semiconductor device on a substrate, the semiconductor device having at least one terminal and at least 2 sides, the substrate being on a first side of the semiconductor device; a back-end-of-line (BEOL) region comprising a plurality of metal layers, and disposed on the opposite side of the semiconductor device from the substrate; and a backside contact in the substrate and in contact with the terminal of the semiconductor device. The backside contact may have a side contacting the terminal, a side contacting a backside power rail, and sidewalls extending from the terminal to the backside power rail. The sidewalls of the backside contact may have a positive slope and may be lined with a dielectric liner.

According to another embodiment, what is provided is a method for forming a semiconductor unit, comprising: forming a semiconductor device on a substrate, the semiconductor device having at least one terminal and at least 2 sides, the substrate being on a first side of the semiconductor device; forming a back-end-of-line (BEOL) region comprising a plurality of metal layers, disposed on the opposite side of the semiconductor device from the substrate; and forming a backside contact in the substrate and in contact with the terminal of the semiconductor device. The backside contact may have a side contacting the terminal, a side contacting a backside power rail, and sidewalls extending from the terminal to the backside power rail. The sidewalls of the backside contact have a positive slope and are lined with a dielectric liner.

### BRIEF DESCRIPTION OF THE DRAWINGS

FIG. 1 depicts one implementation of a backside contact to a semiconductor device.
FIG. 2 depicts a second implementation of a backside contact to a semiconductor device.
FIG. 3 depicts a third implementation of a backside contact to a semiconductor device.
FIG. 4A-4P depict various stages in a process for forming the backside contact shown in FIG. 3.
FIG. 5 is a flowchart for a process for forming a backside contact shown in FIG. 3 and FIGs. 4A-4P.
FIG. 6 illustrates an example semiconductor package according to some embodiments.
FIG. 7 illustrates a schematic block diagram of an electronic system according to some embodiments.

### DETAILED DESCRIPTION

The detailed description set forth below in connection with the appended drawings is intended as a description of some example embodiments of a system and a method for backside contacts to semiconductor devices, provided in accordance with the present disclosure and is not intended to represent the only forms in which the present disclosure may be constructed or utilized. The description sets forth the features of the present disclosure in connection with the illustrated embodiments. It is to be understood, however, that the same or equivalent functions and structures may be accomplished by different embodiments that are also intended to be encompassed within the scope of the disclosure. As denoted elsewhere herein, like element numbers are intended to indicate like elements or features.

It will be understood that, although the terms "first", "second", "third", etc., may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed herein could be termed a second element, component, region, layer or section, without departing from the scope of the present disclosure.

Spatially relative terms, such as "beneath", "below", "lower", "under", "above", "upper" and the like, may be used herein for ease of description to describe one element or feature's relationship to another element(s) or feature(s) as illustrated in the figures. It will be understood that such spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly. In addition, it will also be understood that when a layer is referred to as being "between" two layers, it can be the only layer between the two layers, or one or more intervening layers may also be present.

The terminology used herein is for the purpose of describing particular embodiments only and is not intended to be limiting of the present disclosure. As used herein, the terms "substantially," "about," and similar terms are used as terms of approximation and not as terms of degree, and are intended to account for the inherent deviations in measured or calculated values that would be recognized by those of ordinary skill in the art.

As used herein, the singular forms "a" and "an" are intended to include the plural forms as well, unless the context clearly indicates otherwise. It will be further understood that the terms "comprises" and/or "comprising", when used in this specification, specify the presence of stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. Expressions such as "at least one of," when preceding a list of elements, modify the entire list of elements and do not modify the individual elements of the list. Further, the use of "may" when describing embodiments of the present disclosure refers to "one or more embodiments of the present disclosure". Also, the term "exemplary" is intended to refer to an example or illustration. As used herein, the terms "use," "using," and "used" may be considered synonymous with the terms "utilize," "utilizing," and "utilized," respectively.

It will be understood that when an element or layer is referred to as being "on", "connected to", "coupled to", or "adjacent to" another element or layer, it may be directly on, connected to, coupled to, or adjacent to the other element or layer, or one or more intervening elements or layers may be present. In contrast, when an element or layer is referred to as being "directly on", "directly connected to", "directly coupled to", or "immediately adjacent to" another element or layer, there are no intervening elements or layers present.

Any numerical range recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein and any minimum numerical limitation recited in this specification is intended to include all higher numerical limitations subsumed therein.

The electronic or electric devices and/or any other relevant devices or components according to embodiments of the present disclosure described herein may be implemented utilizing any suitable hardware, firmware (e.g. an application-specific integrated circuit), software, or a combination of software, firmware, and hardware. For example, the various components of these devices may be formed on one integrated circuit (IC) chip or on separate IC chips. Further, the various components of these devices may be implemented on a flexible printed circuit film, a tape carrier package (TCP), a printed circuit board (PCB), formed on one substrate or other appropriate architectures. Further, the various components of these devices may be a process or thread, running on one or more processors, in one or more computing devices, executing computer program instructions and interacting with other system components for performing the various functionalities described herein. The computer program instructions are stored in a memory which may be implemented in a computing device using a standard memory device, such as, for example, a random access memory (RAM). The computer program instructions may also be stored in other non-transitory computer readable media such as, for example, a CD-ROM, flash drive, or the like. Also, a person of skill in the art should recognize that the functionality of various computing devices may be combined or integrated into a single computing device, or the functionality of a particular computing device may be distributed across one or more other computing devices without departing from the spirit and scope of the example embodiments of the present disclosure.

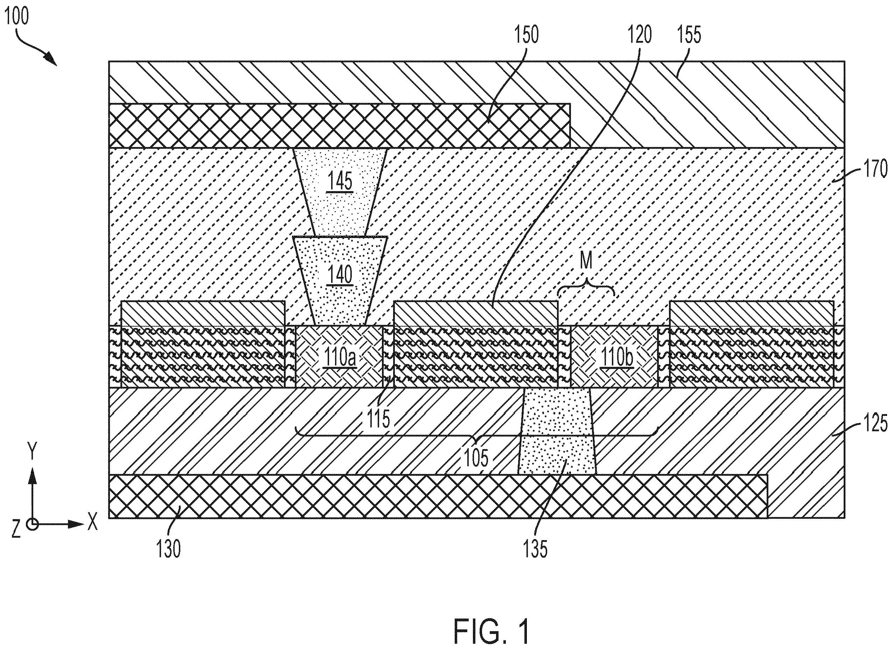

Turning to FIG. 1, a semiconductor unit structure 100 having frontside and backside contacts is shown. More specifically, the semiconductor unit structure 100 comprises a substrate 125, which may comprise a low-K dielectric ILD material, such as SiO₂. Within the substrate 125 may run one or more backside power rails 130. Such backside power rails 130 comprise one or more conductive metals (such as Cu, W, Al, or Ru, amongst others), which run parallel to the major surfaces of the substrate (a top ZX plane and a bottom ZX plane), and can provide power to semiconductor devices 105 within semiconductor unit structure 100, as will be described further herein.

Upon the substrate (that is, stacked in the Y direction) are positioned one or more semiconductor devices 105. Semiconductor device 105 comprises at least 2 major sides or faces; a first side adjacent to the substrate 125, and a second opposite side adjacent to a middle-of-line (MOL) layer 170, discussed later.

Semiconductor devices 105 may comprise any active or passive devices, such as FET transistors, BJTs, diodes, resistors, or the like. In the illustrated embodiment, semiconductor device 105 is a FET transistor, comprising a first source-drain 110a, a second source-drain 110b separated from the first source-drain 110a in the X direction (perpendicular to the Y direction), a channel structure 115 connecting the first and second source-drains 110a-b in the X direction, and a gate structure 120 adjacent to, and at least partially enveloping the channel structure 115. The source-drains 110a-b may be terminals for the semiconductor device 105. Thus, the illustrated semiconductor device 105 may be a FINFET transistor. In other embodiments, the semiconductor device 105 may be a nanosheet transistor, nanowire transistor, planar transistor, or any other form of transistor having one or more terminals. Alternatively, semiconductor device 105 may comprise various passive devices such as diodes, resistors, etc. having one or more terminals.

Upon the semiconductor devices 105 (that is stacked in the Y direction) opposite the substrate may be a middle-of-line (MOL) layer 170. MOL layer 170 may comprise a bulk low-K dielectric ILD material such as SiO₂. Within the MOL layer may be formed one or more contact plugs 140 that contact a source-drain 110a of semiconductor device 105 from above, as well as one or more contact vias 145, contacting the contact plug 140 from above, and contacting a metal line 150 of the back-end-of-line (BEOL) region 155 from below, as will be discussed further below. In alternative embodiments, contact plug 140 (and associated via 145) may instead provide contact between a metal line 150 of the BEOL region 155 and the gate 120- thus providing for signal routing- the metal line 150 being a signal routing metal line in such an example.

Upon the MOL layer 170 (that is, stacked in the Y direction), and opposite the semiconductor devices 105, may be a group of layers collectively called the back-end-of-line (BEOL) region 155. BEOL regions 155 may comprise a bulk low-K dielectric ILD material such as SiO₂. Within the BEOL region 155 are a series of stacks of metal layers lines 150 within a series of metal layers (one shown for convenience), the metal lines 150 running parallel to the major surfaces of the substrate and the BEOL region, (a top ZX plane and a bottom ZX plane). The metal lines may contact vias such as via 145 to provide power or signals to semiconductor device 105. The stacked metal layers/ metal lines 150 within BEOL region 155 may be inter connected by vias, not shown.

Importantly, the substrate 125 also comprises at least one metal line that may serve as a backside power rail 130. To connect the backside power rail 130 to the source-drain 110b of the semiconductor device 105, a backside contact 135 may be formed, thus allowing power to flow from power rail 130 to source-drain 110b.

However, some methods of forming backside contact 135, such as the formation of direct backside contacts by a wafer-bonding strategy, can cause significant misalignments M between the backside contact 135 and the source-drain 110b. As illustrated here, misalignment M has caused backside contact 135 to also contact portions of the channel structure 115 and gate structure 120. This may cause the circuit to malfunction. Such misalignments may be caused by inaccurate wafer alignment, or by wafer warpage.

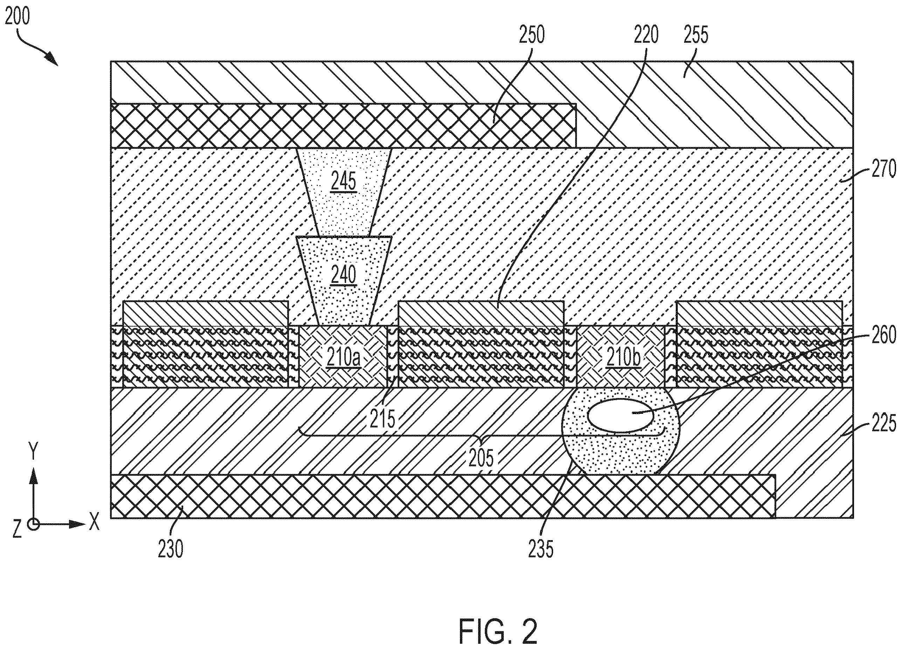

FIG. 2 illustrates an alternative backside contact for a semiconductor unit structure 200. The semiconductor unit structure 200 is similar in many ways to the semiconductor unit structure 100 of FIG. 1. Turning to FIG. 2, a semiconductor unit structure 200 having frontside and backside contacts is shown. More specifically, the semiconductor unit structure 200 comprises a substrate 225, which may comprise a low-K dielectric ILD material, such as SiO₂. Within the substrate 225 may run one or more backside power rails 230. Such backside power rails 230 comprise one or more conductive metals (such as Cu, W, Al, or Ru, amongst others), and which run parallel to the major surfaces of the substrate (a top ZX plane and a bottom ZX plane), and can provide power to semiconductor devices 205 within semiconductor unit structure 200, as will be described further herein.

Upon the substrate (that is, stacked in the Y direction) are positioned one or more semiconductor devices 205. Semiconductor device 205 comprises at least 2 major sides or faces; a first side adjacent to the substrate 225, and a second opposite side adjacent to a middle-of-line (MOL) layer 270, discussed later.

Semiconductor devices 205 may comprise any active or passive devices, such as FET transistors, BJTs, diodes, resistors, or the like. In the illustrated embodiment, semiconductor device 205 is a FET transistor, comprising a first source-drain 210a, a second source-drain 210b separated from the first source-drain 210a in the X direction (perpendicular to the Y direction), a channel structure 215 connecting the first and second source-drains 210a-b in the X direction, and a gate structure 220 adjacent to, and at least partially enveloping the channel structure 215. The source-drains 210a-b may be terminals for the semiconductor device 205. Thus, the illustrated semiconductor device 205 may be a FINFET transistor. In other embodiments, the semiconductor device 205 may be a nanosheet transistor, nanowire transistor, planar transistor, or any other form of transistor having one or more terminals. Alternatively, semiconductor device 205 may comprise various passive devices such as diodes, resistors, etc. having one or more terminals.

Upon the semiconductor devices 205 (that is stacked in the Y direction) opposite the substrate may be a middle-of-line (MOL) layer 270. MOL layer 270 may comprise a bulk low-K dielectric ILD material such as SiOz. Within the MOL layer may be formed one or more contact plugs 240 that contact a source-drain 210a of semiconductor device 205 from above, as well as one or more contact vias 245, contacting the contact plug 240 from above, and contacting a metal line 250 of the back-end-of-line (BEOL) region 155 from below, as will be discussed further below. In alternative embodiments, contact plug 240 (and associated via 245) may instead provide contact between a metal line 250 of the BEOL region 255 and the gate 220- thus providing for signal routing- the metal line 250 being a signal routing metal line in such an example.

Upon the MOL layer 270 (that is, stacked in the Y direction), and opposite the semiconductor devices 205, may be a group of layers collectively called the back-end-of-line (BEOL) region 255. BEOL region 255 may comprise a bulk low-K dielectric ILD material such as SiO₂. Within the BEOL region are a series of stacks of metal layers lines 250 within a series of metal layers (one shown for convenience), the metal lines 250 running parallel to the major surfaces of the substrate and the BEOL region, (a top ZX plane and a bottom ZX plane). The metal lines may contact vias such as via 245 to provide power or signals to semiconductor device 205. The stacked metal layers/ metal lines 250 within BEOL region 255 may be connected by vias, not shown.

Importantly, the substrate 225 also comprises at least one metal line that may serve as a backside power rail 230. To connect the backside power rail 230 to the source-drain 210b of the semiconductor device 205, a backside contact 235 may be formed, thus allowing power to flow from power rail 230 to source-drain 210b.

A major difference between the semiconductor unit structure 100 of FIG. 1 and the semiconductor unit structure 200 of FIG. 2 is the backside contact 235 of FIG. 2. The backside contact 235 of FIG. 2 may be produced through a different method from the backside contact 135 of FIG. 1. Backside contact 235 may be formed by a self-aligned process. That is, it is formed by etching, down from above (approximately along the Y axis), through the space that will later be occupied by source-drain 210b, to form a contact region below the future source-drain 210b. Thus, backside contact 235 is always aligned with the later-formed source-drain 210b. However, etching for the self-aligned process used in FIG. 2 is difficult to control-especially at higher aspect ratios (IE, great Y-heights compared to X-widths). This may cause the shape of the backside contact 235 to bulge out or warp unexpectedly in places compared to the backside contact 135 of FIG. 1. This poorly-controlled shape tends to allow for the formation of voids 260 within the backside contact 235 during a metal fill process. Such voids 260 increase resistance, and can cause device failure.

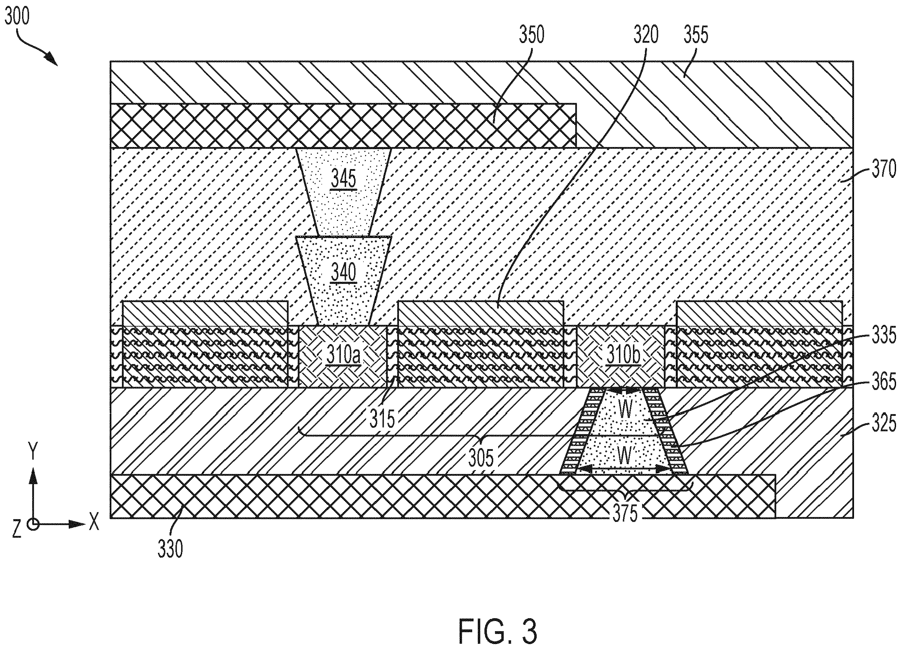

Turning to FIG. 3, what is shown is an alternative structure for a backside contact 335 for a semiconductor unit structure 300. In FIG. 3, a semiconductor unit structure 300 having frontside and backside contacts is shown. More specifically, the semiconductor unit structure 300 comprises a substrate 325, which may comprise a low-K dielectric ILD material, such as SiO₂. Within the substrate 325 may run one or more backside power rails 330. Such backside power rails 330 comprise one or more conductive metals (such as Cu, W, Al, or Ru, amongst others), which run parallel to the major surfaces of the substrate (a top ZX plane and a bottom ZX plane), and can provide power to any semiconductor devices 305 within semiconductor unit structure 300, as will be described further herein.

Upon the substrate (that is, stacked in the Y direction) are positioned one or more semiconductor devices 305. Semiconductor devices 305 comprises at least 2 major sides or faces; a first adjacent to the substrate 325, and a second opposite side adjacent to a middle-of-line (MOL) layer 370, discussed later.

Semiconductor devices 305 may comprise any active or passive devices, such as FET transistors, BJTs, diodes, resistors, or the like. In the illustrated embodiment, semiconductor device 305 is a FET transistor, comprising a first source-drain 310a, a second source-drain 310b separated from the first source-drain 110a in the X direction (perpendicular to the Y direction), a channel structure 315 connecting the first and second source-drains 310a-b in the X direction, and a gate structure 320 adjacent to, and at least partially enveloping the channel structure 315. The source-drains 310a-b may be terminals for the semiconductor device 305. Thus, the illustrated semiconductor device 305 may be a FINFET transistor. In other embodiments, the semiconductor device 305 may be a nanosheet transistor, nanowire transistor, planar transistor, or any other form of transistor having one or more terminals. Alternatively, semiconductor device 305 may comprise various passive devices such as diodes, resistors, etc. having one or more terminals.

Upon the semiconductor devices 305 (that is stacked in the Y direction) opposite the substrate may be a middle-of-line (MOL) layer 370. MOL layer 370 may comprise a bulk low-K dielectric ILD material such as SiO₂. Within the MOL layer may be formed one or more contact plugs 340 that contact a source-drain 310a of semiconductor device 305 from above, as well as one or more contact vias 345, contacting the contact plug 340 from above, and contacting a metal line 350 of the back-end-of-line (BEOL) region 355 from below, as will be discussed further below. In alternative embodiments, contact plug 340 (and associated via 345) may instead provide contact between a metal line 350 of the BEOL region 355 and the gate 320- thus providing for signal routing- the metal line 350 being a signal routing metal line in such an example.

Upon the MOL layer 370 (that is, stacked in the Y direction), and opposite the semiconductor devices 305, may be a group of layers collectively called the back-end-of-line (BEOL) region 355. BEOL region 355 may comprise a bulk low-K dielectric ILD material such as SiO₂. Within the BEOL region are a series of stacks of metal layers lines 350 within a series of metal layers (one shown for convenience), the metal lines 350 running parallel to the major surfaces of the substrate and the BEOL region, (a top ZX plane and a bottom ZX plane). The metal lines may contact vias such as via 345 to provide power or signals to semiconductor device 305. The stacks metal layers/ metal lines 350 within BEOL region 355 may be connected by vias, not shown.

Importantly, the substrate 325 also comprises at least one metal line that may serve as a backside power rail 330.

Significantly, the semiconductor unit structure 300 of FIG. 3 comprises a backside contact structure 375. Backside contact structure 375 comprises a backside contact 335 having a first side contacting source-drain 310b, a second side opposite the first side (e.g. separated in the Y direction) contacting the backside power rail 330, and sidewalls defining the surface of backside contact 335 facing the substrate 325, said sidewalls having a positive slope. (Herein, "positive slope" indicates that the sidewalls of backside contact 335 lean outward in such a way that the width W of the backside contact 335, where it contacts the source-drain 310b, is less than the width W' of the backside contact 335 where it contacts the backside power rail 330.) Further, backside contact structure 375 comprises a dielectric liner 365 along the sidewalls of the backside contact 335, in between the backside contact 335 and the substrate 325. This dielectric liner 365 provides for additional short protection between the backside contact 335 and the channel structure 315 and/or the gate structure 320, especially in cases where there is no bottom dielectric layer (not shown) between the substrate 325 and the semiconductor devices 305. In some embodiments, the sidewalls of backside contact 335 are unwarped- that is, they are substantially straight. The dielectric liner 365 may comprise one or more of: SiN, AlN, SiOC, SiON, or SiO₂. The backside contact 335 may comprise one or more of W or Co.

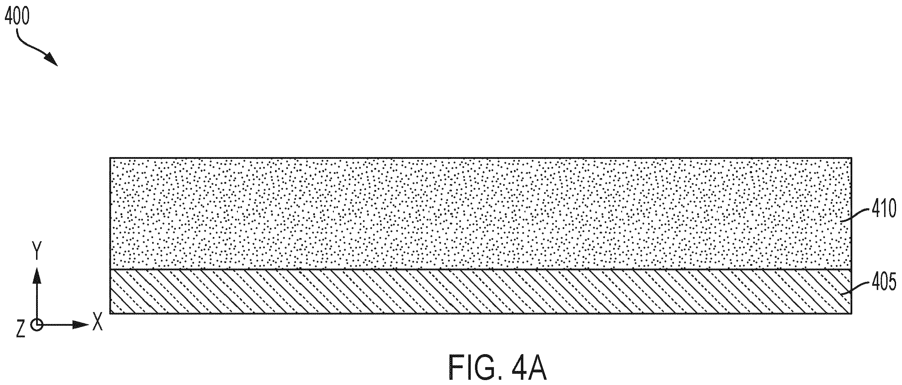

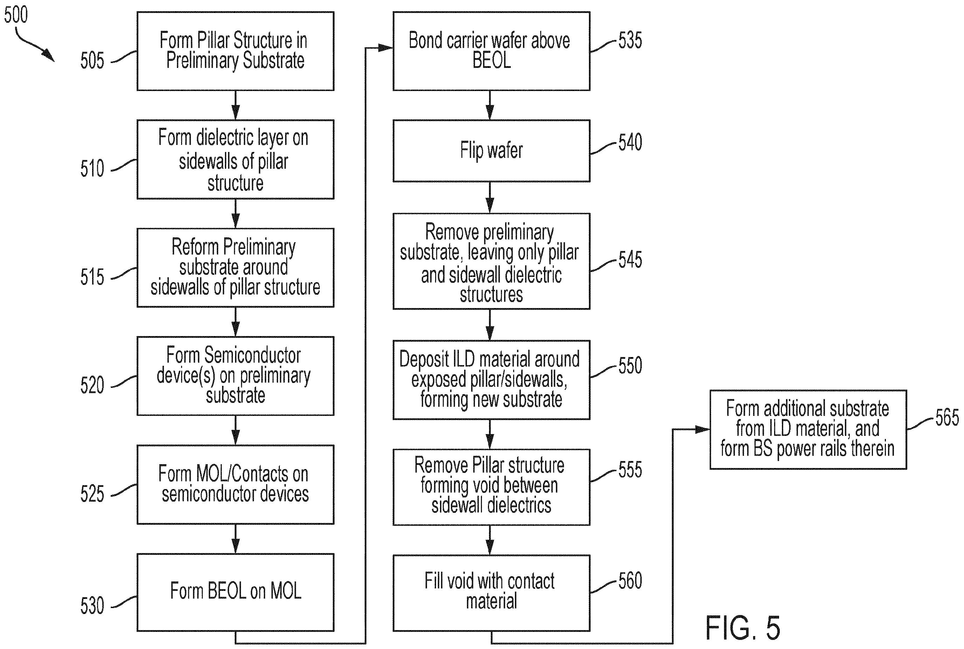

FIG. 4A-4P provide a visual depiction of a process for forming the semiconductor unit structure 300 of FIG. 3. FIG. 5 provides a flow chart for the process depicted in FIG. 4A-4P. As the structure being produced is the structure shown in FIG. 3, like numberings are kept where applicable, and duplicative descriptions are omitted for brevity.

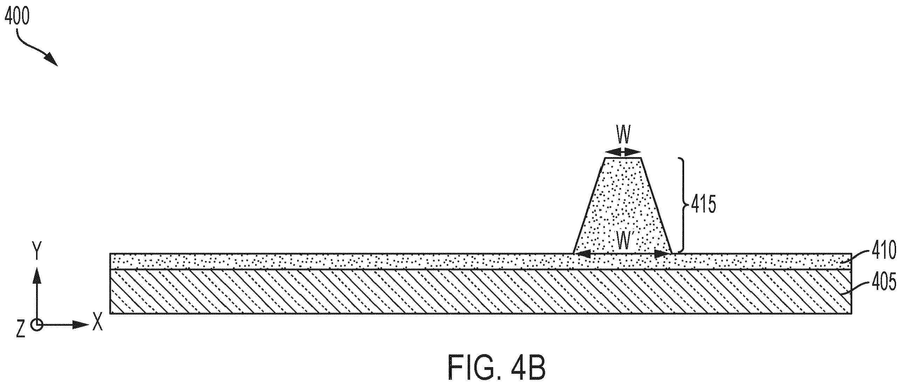

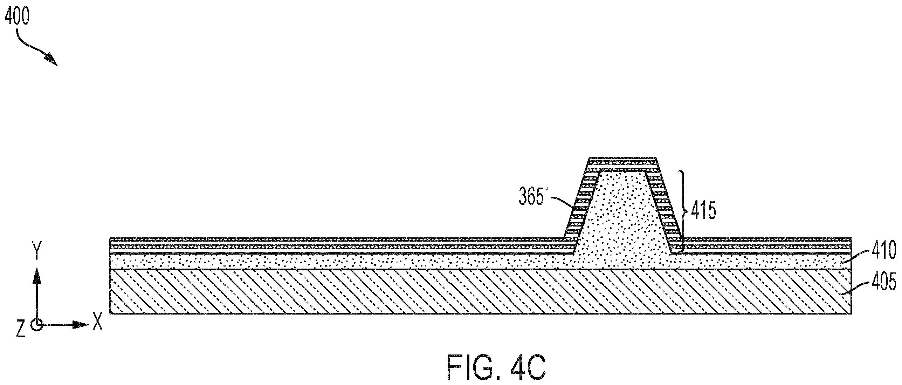

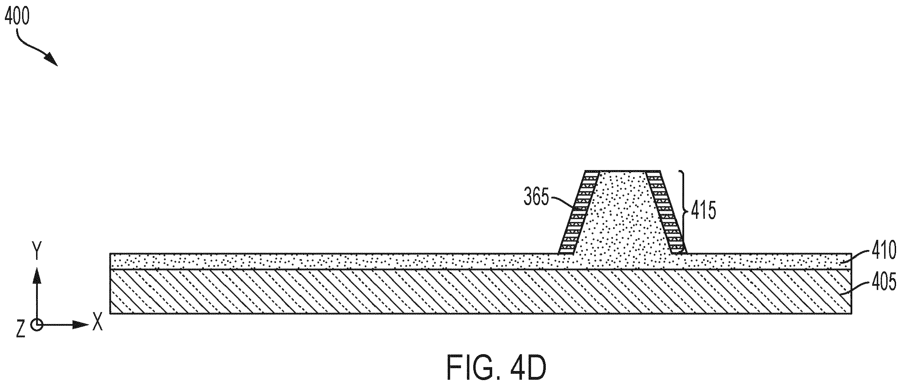

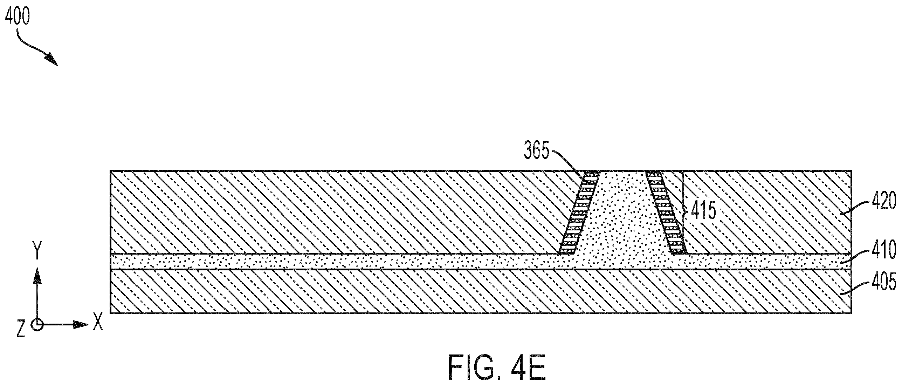

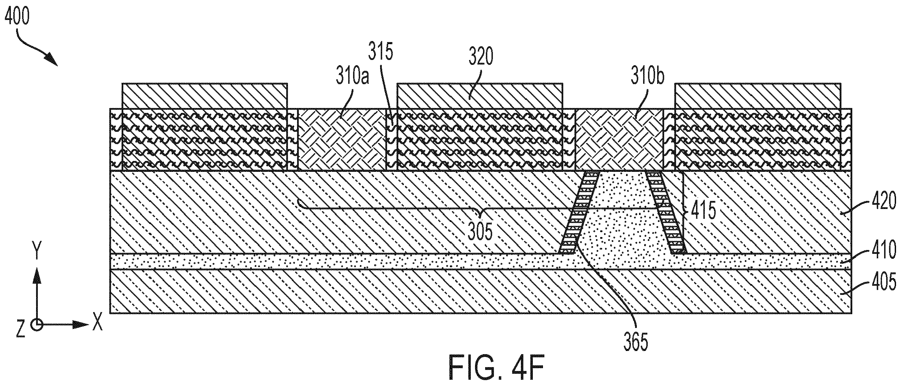

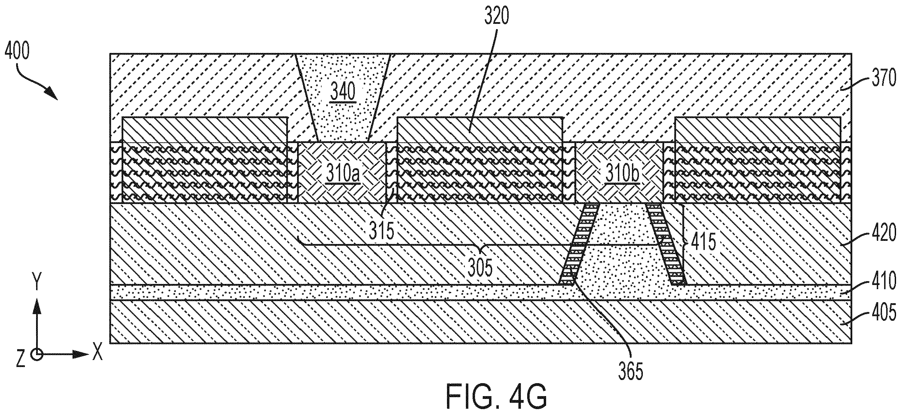

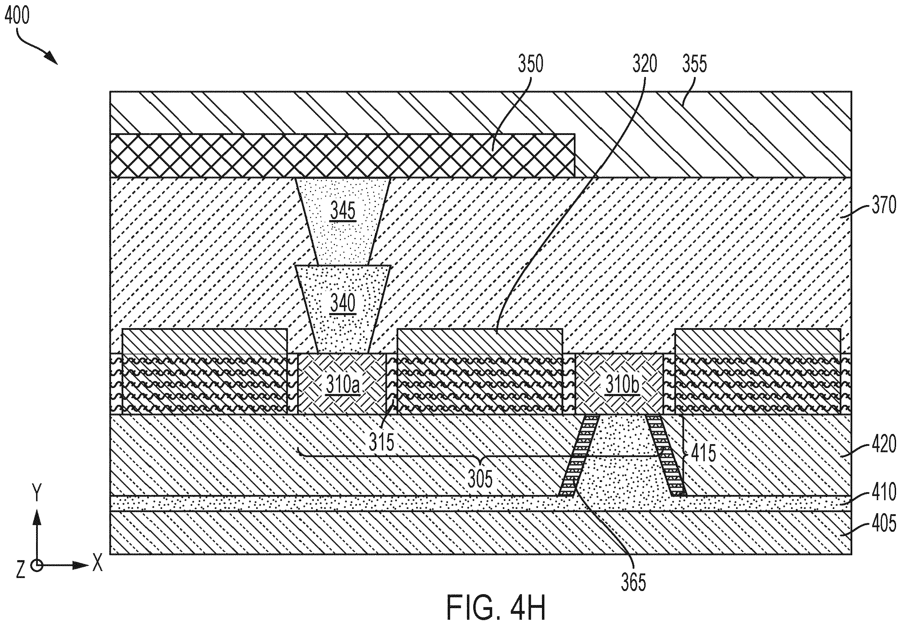

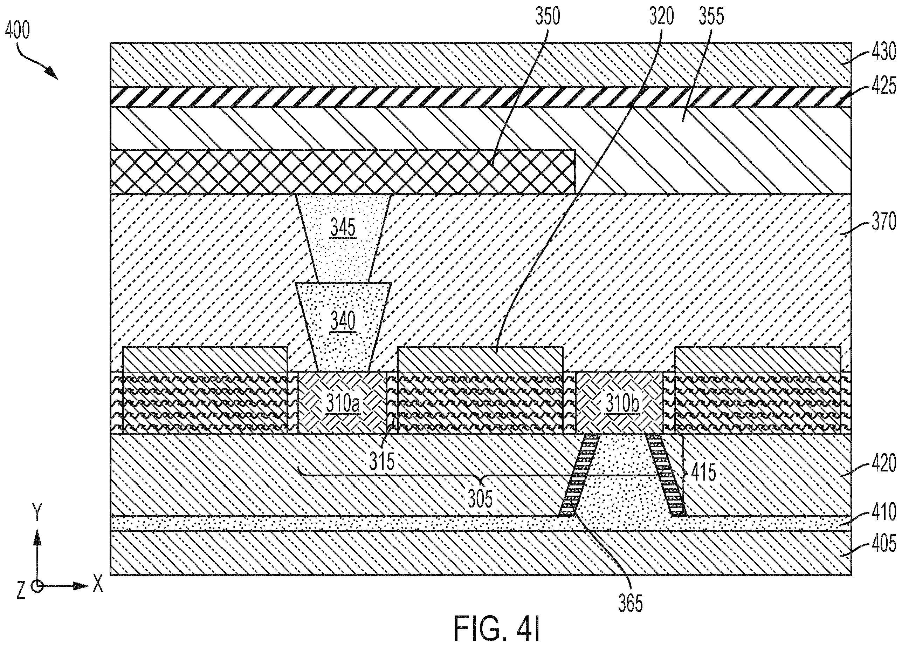

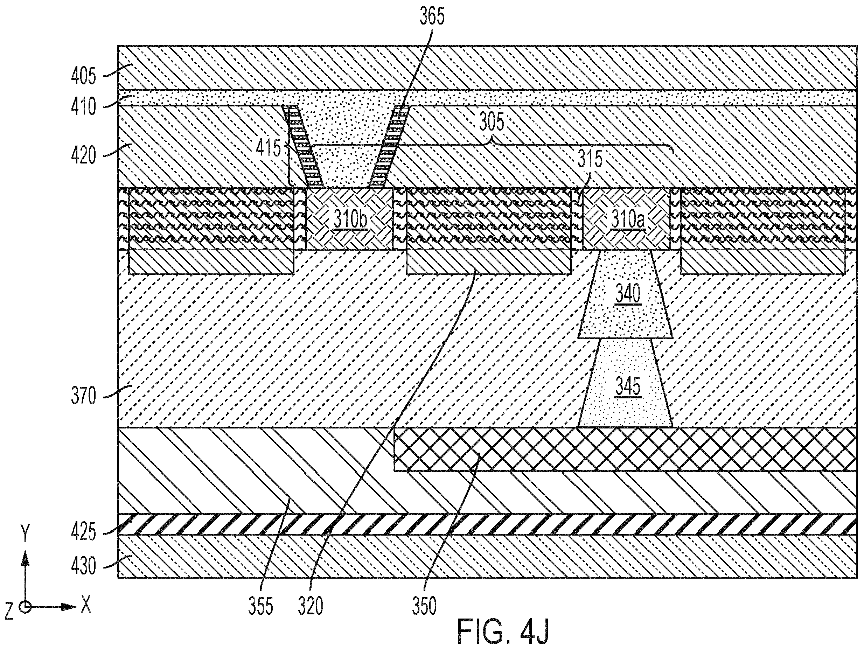

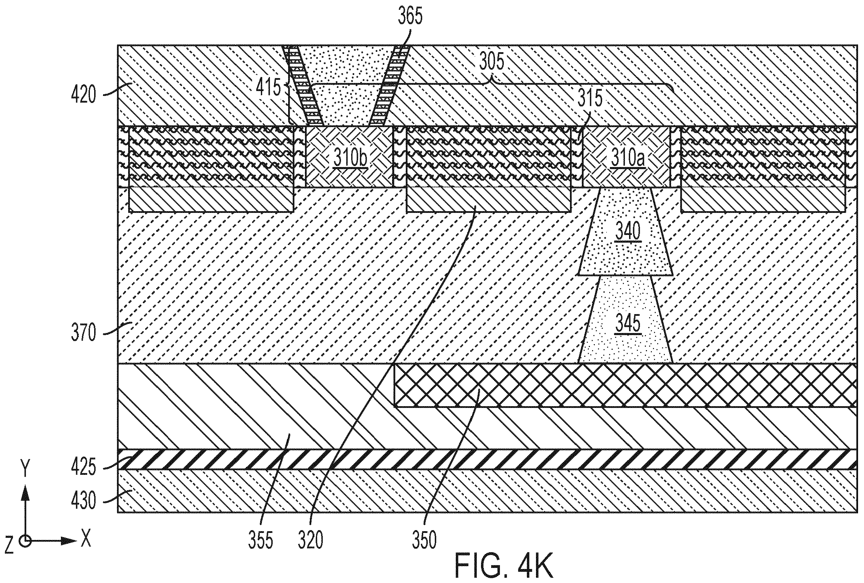

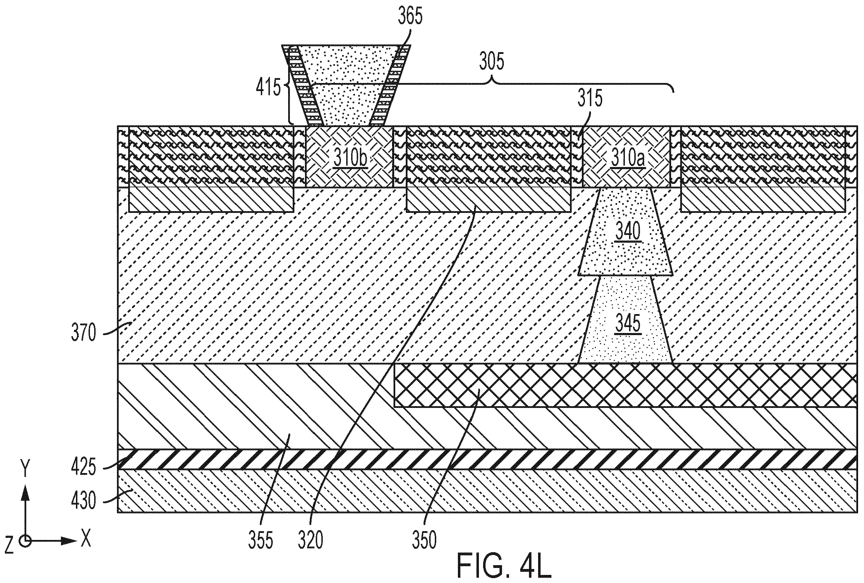

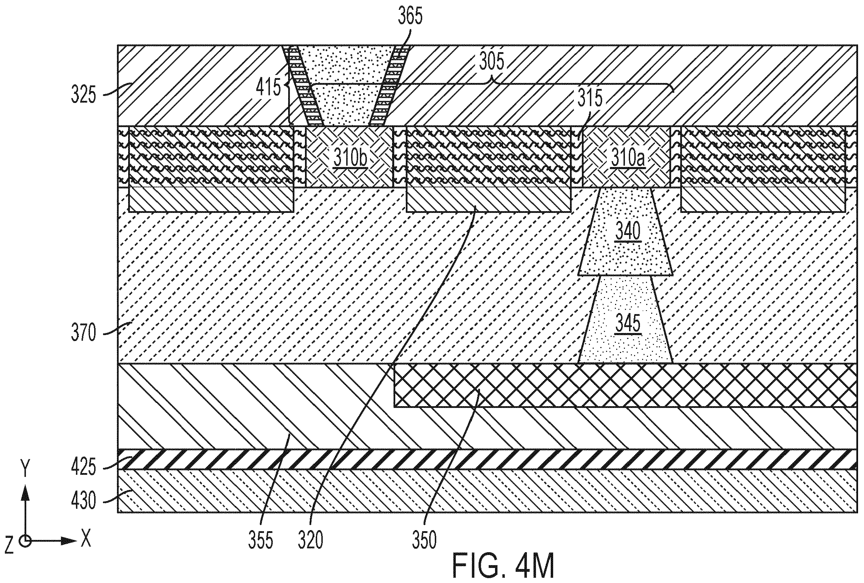

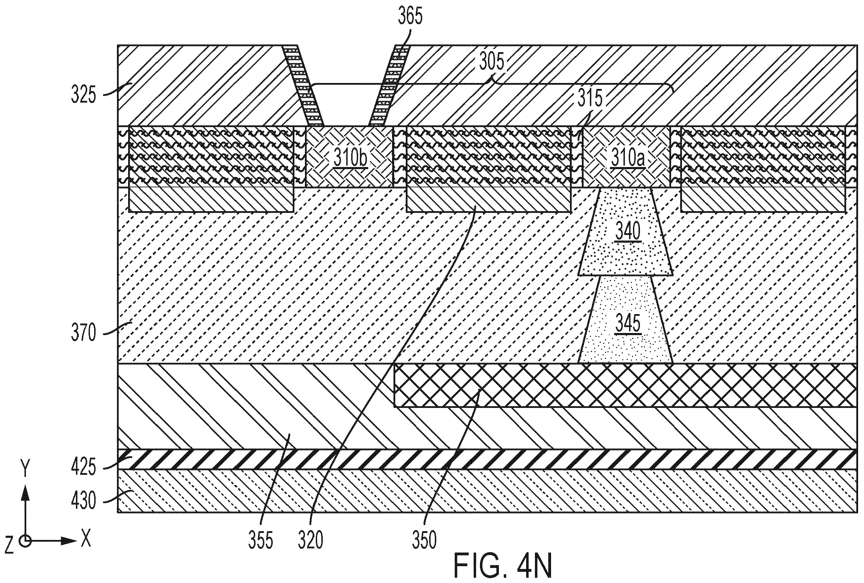

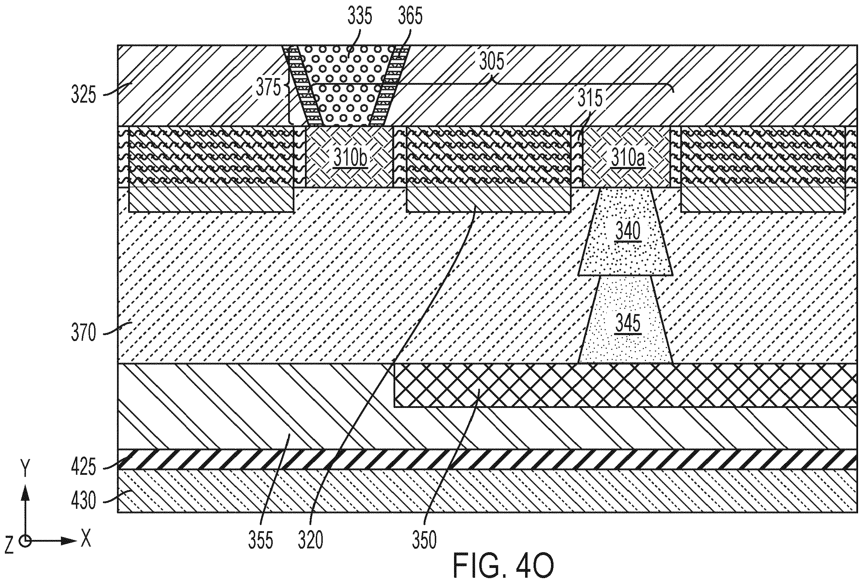

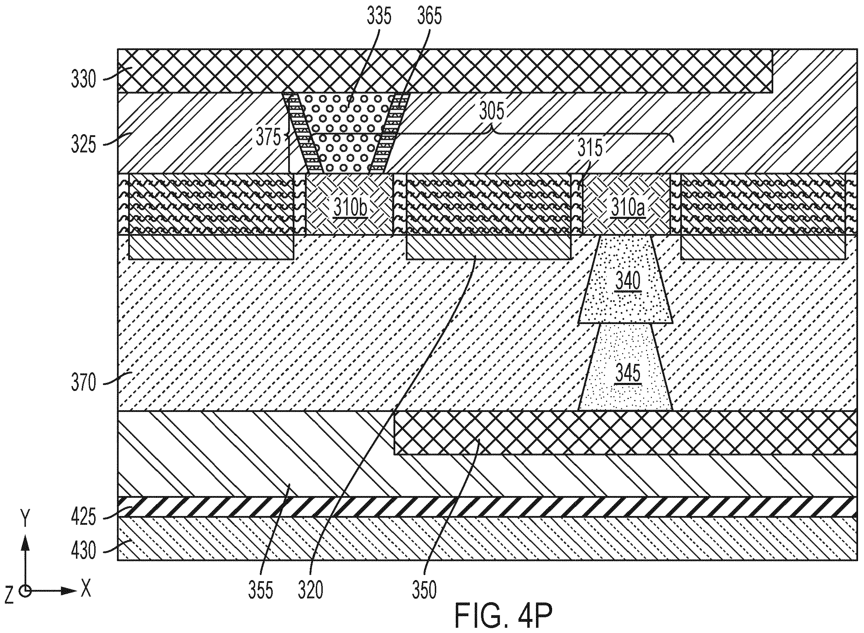

Turning now to FIGs. 4A and 5, what is illustrated is a preliminary substrate 400, comprising a silicon layer 405 and a SiGe layer 410, which serves as the basis for the process. Since the process of FIGs. 4 and 5 result in the semiconductor unit of FIG. 3, like numbers are retained, and duplicative descriptions are omitted for brevity.

At process 505, shown by example in FIG. 4B, a pillar structure 415 has been etched in the SiGe layer. This etching may be done through a standard mask-and etch process. Note that due to the standard etching process, the pillar structure 415 has a trapezoidal shape, with the wider portion of width W' at the base, and the narrower portion W exposed.

At process 510, a dielectric liner 365 may be formed on the sidewalls of the pillar structure 415, as illustrated by example in FIGs. 4C-4D. In FIG. 4C, a dielectric liner 365' may be conformally deposited on the preliminary substrate 400, including the pillar structure 415. At FIG. 4D, an anisotropic etch process removes a portion of the conformally deposited dielectric liner 365' not on the sidewalls of pillar structure 415- leaving dielectric liner 365 remaining on the sidewalls of pillar structure 415. The dielectric liner 365 may comprise one or more of the following: SiN, AlN, SiOC, SiON, or SiO₂.

At process 515, as shown by example in FIG. 4E, a silicon layer 420 may be deposited around the dielectric liner 365 and above the substrate, returning the preliminary substrate to its original thickness in the Y direction; that is, in some embodiments, the height of the substrate may be such that the upper surface of pillar structure 415 may be exposed, and co-planar with the top of the added silicon layer 420. This may be accomplished through epitaxial growth and chemical-mechanical polishing (CMP).

At process 520, as shown by example in FIG. 4F, FEOL structures (e.g., semiconductor device 305 components including source/drains 310a-b, channel 315, and gate structure 320) are formed on the silicon layer 420, dielectric liner 365, and pillar structure 415. Note that the source/drain 310b may be formed above and aligned with pillar 415. The FEOL formation process may involve the formation, deposition, and/or etching of semiconductor layers on or above the preliminary substrate 400, and may be accomplished by any means known in the art or discovered hereinafter.

At process 525, as shown by example in FIG. 4G, MOL structures and layer 370, including contact plug 340, are formed above the FEOL/device structures. This may involve the deposition of an ILD layer forming the bulk of MOL layer 370, and the etching-and-filling of contact plug 340, aligned with source/drain 310a.

At process 530, as shown by example in FIG. 4H, BEOL structures are formed on MOL structures and layer 370. This may include the formation of one or more dielectric layers forming BEOL region 355, and one or more metal layers including metal lines 350 therein. Also during BEOL processing, vias 345 may be formed to connect contact plug 340 with metal line 350.

At process 535, as shown by example in FIG. 4I, a carrier wafer 430 may be bonded to the BEOL region 355, in some embodiment using a bonding oxide layer 425.

At a process 540, as shown by example in FIG. 4J, the wafer stack may be flipped using the carrier wafer 430. Thus, the preliminary substrate 400 and its structures including the pillar structure 415 and dielectric liner 365 are at the top, followed by the FEOL structures, the MOL structures, the BEOL region, and finally the carrier wafer 430 at the bottom.

At process 545, having example illustrations in FIGs. 4K-4L, the preliminary substrate may be removed. In FIG. 4K, the silicon layer 405 may be etched to reveal the SiGe layer 410, as an etch-stop layer; this is followed by removal of the SiGe layer 410 down to the silicon layer 420 in a controlled etch. This exposes the pillar structure 415. CMP may be done to planarize the results of this etch. In FIG. 4L, the silicon layer 420 may be etched away, stopping at the FEOL structures, and leaving behind the pillar structure 415 and the dielectric liners 365.

At process 550, as shown by example in FIG. 4M, a "new" substrate may be deposited, comprising ILD material, to make substrate 325, replacing the Silicon material 420 that was previously present in the preliminary substrate. At this step, the ILD may be deposited to a level to be co-planar with the exposed top surface of the pillar structure 415. This may be leveled and planarized via CMP.

At process 555, as shown by example in FIG. 4N, the pillar structure 415 may be etched away via a selective etch vs the ILD material of substrate 325 and the dielectric liner 365, leaving a void.

At process 560, as shown by example in FIG. 4O, the void of process 555 may be filled with a conductive contact material, such as W or Co; thus, creating backside contact structure 375, including a backside contact 335 that is in contact with the source/drain 310b, and dielectric liners 365 on the sidewalls thereof.

At process 565, as shown by example in FIG. 4P the substrate may be thickened, and backside power rails 330 are formed. The substrate may be thickened by depositing additional ILD material of substrate 325, and backside power rails may be formed via an etch-and-fill processes. The backside power rails 330 may be formed of a conductive material such as one or more of the following: Ru, Cu, Mo, or Al.

Note that the process of FIG. 5, as illustrated in FIGs. 4A-4P, is one example of many of how the structures of FIG. 3 may be formed. Importantly, other procedures may be used, or the steps shown may be done in a different order, and still meet the concepts presented herein. As just one example, the processes listed as 555 and 560 of FIG. 5 may be done before or after the (re)-formation of the new substrate described at process 550. More specifically, when the pillar structure 415 is exposed in FIG. 4K, it may be replaced with backside contact 335 according to the processes of 555 and 560. Other steps may be performed out of order, as one skilled in the art will recognize after having read this disclosure.

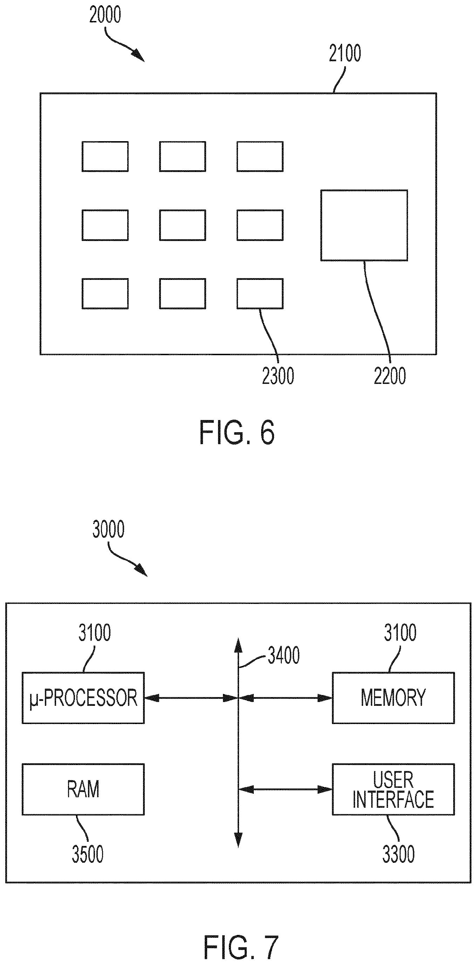

Referring to FIG. 6, a semiconductor package 2000 according to an example embodiment may include a processor 2200 and semiconductor units 2300 that are mounted on a substrate 2100. The processor 2200 and/or the semiconductor units 2300 may include one or more of the semiconductor units 300 of FIG. 3 described above.

FIG. 7 illustrates a schematic block diagram of an electronic system according to an example embodiment.

Referring to FIG. 7, an electronic system 3000 in accordance with an embodiment may include a microprocessor 3100, a memory 3200, and a user interface 3300 that perform data communication using a bus 3400. The microprocessor 3100 may include a central processing unit (CPU) or an application processor (AP). The electronic system 3000 may further include a random access memory (RAM) 3500 in direct communication with the microprocessor 3100. The microprocessor 3100 and/or the RAM 3500 may be implemented in a single module or package. The user interface 3300 may be used to input data to the electronic system 3000, or output data from the electronic system 3000. For example, the user interface 3300 may include a keyboard, a touch pad, a touch screen, a mouse, a scanner, a voice detector, a liquid crystal display (LCD), a micro light-emitting device (LED), an organic light-emitting diode (OLED) device, an active-matrix light-emitting diode (AMOLED) device, a printer, a lighting, or various other input/output devices without limitation. The memory 3200 may store operational codes of the microprocessor 3100, data processed by the microprocessor 3100, or data received from an external device. The memory 3200 may include a memory controller, a hard disk, or a solid state drive (SSD).

At least the microprocessor 3100, the memory 3200 and/or the RAM 3500 in the electronic system 3000 may the semiconductor units 300 of FIG. 3.

It should be understood that example embodiments described herein should be considered in a descriptive sense only and not for purposes of limitation. Descriptions of features or aspects within each example embodiment should typically be considered as available for other similar features or aspects in other embodiments.

While example embodiments have been described with reference to the figures, it will be understood by those of ordinary skill in the art that various changes in form and details may be made therein without departing from the scope as defined by the claims. Some example embodiments set forth herein include, but are not limited to the following statements:
Statement 1: A semiconductor unit comprising:
   A semiconductor device on a substrate, the semiconductor device having at least one terminal and at least 2 sides, the substrate being on a first side of the semiconductor device;
   A back-end-of-line (BEOL) region comprising a plurality of metal layers, and disposed on the opposite side of the semiconductor device from the substrate;
   A backside contact in the substrate and in contact with the terminal of the semiconductor device;
   Wherein the backside contact has a side contacting the terminal, a side contacting a backside power rail, and sidewalls extending from the terminal to the backside power rail; and
   Wherein the sidewalls of the backside contact have a positive slope and are aligned with a dielectric liner.
Statement 2. The semiconductor unit of statement 1, wherein the dielectric liner comprises at least one material from the set of: SiN, AlN, SiOC, SiON, and SiO₂
Statement 3. The semiconductor unit of statement 1, additionally comprising a middle-of-line (MOL) region between the semiconductor device and the BEOL region, wherein the MOL layer comprises at least one of a front-side contact or a via, connecting the semiconductor device to the BEOL metal layers.
Statement 4. The semiconductor unit of statement 1, wherein the BEOL metal layers comprise signal routing layers.
Statement 5. The semiconductor unit of statement 1, wherein the backside contact comprises at least one material from the set of: W and Co.
Statement 6. The semiconductor unit of statement 1, wherein the backside power rail comprises at least one material from the set of: Ru, Cu, Mo, and Al.
Statement 7. The semiconductor unit of statement 1, wherein the sidewalls of the backside contact are substantially straight.
Statement 8. A method for forming a semiconductor unit, comprising:
   Forming a semiconductor device on a substrate, the semiconductor device having at least one terminal and at least 2 sides, the substrate being on a first side of the semiconductor device;
   Forming a back-end-of-line (BEOL) region comprising a plurality of metal layers, disposed on the opposite side of the semiconductor device from the substrate;
   Forming a backside contact in the substrate and in contact with the terminal of the semiconductor device;
   Wherein the backside contact has a first side contacting the terminal, a second, opposite side contacting a backside power rail, and sidewalls extending from the terminal to the backside power rail; and
   Wherein the sidewalls of the backside contact have a positive slope and are lined with a dielectric liner.
Statement 9. The method of statement 8, wherein forming the backside contact comprises:
   Forming, on a preliminary substrate, a pillar structure having sloped sidewalls, the pillar sloped so that the widest end is in contact with the preliminary substrate.
Statement 10. The method of statement 9, wherein forming the backside contact additionally comprises:
   Forming, on the sidewalls of the pillar structure, the sidewall dielectric lining.
Statement 11. The method of statement 10, wherein forming the backside contact additionally comprises:
   forming, around the pillar sidewalls, additional preliminary substrate, such that the preliminary substrate is level with the top of the pillar structure.
Statement 12. The method of statement 11, wherein the forming a semiconductor device comprises:
   Forming a semiconductor device on the preliminary substrate, wherein at least one terminal of the semiconductor device is formed contacting the pillar.
Statement 13. The method of statement 11, wherein the substrate is formed by etching away the preliminary substrate, and replacing it with a dielectric material.
Statement 14. The method of statement 9, wherein forming the backside contact additionally comprises:
   Etching out the pillar, and replacing it with a metal contact.
Statement 15. The method of statement 14, wherein the backside power rail is formed contacting the backside contact on a side opposite the side contacting the terminal of the semiconductor device.

## Claims

1. A semiconductor unit comprising:
a semiconductor device on a substrate, the semiconductor device having at least one terminal and at least 2 sides, the substrate being on a first side of the semiconductor device;
a back-end-of-line, BEOL, region comprising a plurality of metal layers, and disposed on the opposite side of the semiconductor device from the substrate; and
a backside contact in the substrate and in contact with the terminal of the semiconductor device;
wherein the backside contact has a side contacting the terminal, a side contacting a backside power rail, and sidewalls extending from the terminal to the backside power rail; and
wherein the sidewalls of the backside contact have a positive slope and are lined with a dielectric liner.

2. The semiconductor unit of claim 1, wherein the dielectric liner comprises at least one material from the set of: SiN, AlN, SiOC, SiON, and SiO₂

3. The semiconductor unit of claim 1 or 2, additionally comprising a middle-of-line, MOL, region between the semiconductor device and the BEOL region, wherein the MOL layer comprises at least one of a front-side contact or a via, connecting the semiconductor device to the BEOL metal layers.

4. The semiconductor unit of any one of claims 1 to 3, wherein the BEOL metal layers comprise signal routing layers.

5. The semiconductor unit of any one of claims 1 to 4, wherein the backside contact comprises at least one material from the set of: W and Co.

6. The semiconductor unit of any one of claims 1 to 5, wherein the backside power rail comprises at least one material from the set of: Ru, Cu, Mo, and Al.

7. The semiconductor unit of any one of claims 1 to 6, wherein the sidewalls of the backside contact are substantially straight.

8. A method for forming a semiconductor unit, comprising:
forming a semiconductor device on a substrate, the semiconductor device having at least one terminal and at least 2 sides, the substrate being on a first side of the semiconductor device;
forming a back-end-of-line, BEOL, region comprising a plurality of metal layers, disposed on the opposite side of the semiconductor device from the substrate; and
forming a backside contact in the substrate and in contact with the terminal of the semiconductor device;
wherein the backside contact has a first side contacting the terminal, a second, opposite side contacting a backside power rail, and sidewalls extending from the terminal to the backside power rail; and
wherein the sidewalls of the backside contact have a positive slope and are lined with a dielectric liner.

9. The method of claim 8, wherein forming the backside contact comprises:
forming, on a preliminary substrate, a pillar structure having sloped sidewalls, the pillar sloped so that the widest end is in contact with the preliminary substrate.

10. The method of claim 9, wherein forming the backside contact additionally comprises:
forming, on the sidewalls of the pillar structure, the sidewall dielectric liner.

11. The method of claim 10, wherein forming the backside contact additionally comprises:
forming, around the pillar sidewalls, additional preliminary substrate, such that the preliminary substrate is level with the top of the pillar structure.

12. The method of claim 11, wherein the forming a semiconductor device comprises:
forming a semiconductor device on the preliminary substrate, wherein at least one terminal of the semiconductor device is formed contacting the pillar.

13. The method of claim 11 or 12, wherein the substrate is formed by etching away the preliminary substrate, and replacing it with a dielectric material.

14. The method of any one of claims 9 to 13, wherein forming the backside contact additionally comprises:
etching out the pillar, and replacing it with a metal contact.

15. The method of claim 14, wherein the backside power rail is formed contacting the backside contact on a side opposite the side contacting the terminal of the semiconductor device.
